Europäisches Patentamt

European Patent Office

Office européen des brevets

(11) Publication number: **0 184 940**
**B1**

(12) **EUROPEAN PATENT SPECIFICATION**

(45) Date of publication of patent specification: **04.04.90**

(51) Int. Cl.⁵: **F 02 D 41/20**

(21) Application number: **85309047.0**

(22) Date of filing: **12.12.85**

(54) A method of controlling electromagnetic actuators and a controller therefor.

(30) Priority: **12.12.84 JP 262232/84**

(43) Date of publication of application:
**18.06.86 Bulletin 86/25**

(45) Publication of the grant of the patent:
**04.04.90 Bulletin 90/14**

(84) Designated Contracting States:
**AT CH DE FR GB LI NL SE**

(56) References cited:
**EP-A-0 034 076**
**GB-A-2 052 794**
**US-A-3 699 413**
**US-A-3 705 333**
**US-A-4 154 198**

(73) Proprietor: **TECHNOLOGICAL RESEARCH ASSOCIATION OF HIGHLY RELIABLE MARINE PROPULSION PLANT**
**3-8, Mejiro 1-chome Toshima-ku**
**Tokyo 171 (JP)**

(72) Inventor: **Nagata, Osamu**
**8-12-503 Kumochicho 1-chome**
**Chuo-ku Kobe-Shi (JP)**
Inventor: **Ozaki, Toshiharu**
**4-15 Sugahara 4-chome**
**Higashiyodogawa-ku Osaka-shi (JP)**
Inventor: **Kajima, Takashi**
**20-39-302 Kitaoogi 3-chome**
**Higashinada-ku Kobe-shi (JP)**

(74) Representative: **Barnard, Eric Edward et al**
**BROOKES & MARTIN High Holborn House 52/54**
**High Holborn**
**London WC1V 6SE (GB)**

Courier Press, Leamington Spa, England.

EP 0 184 940 B1

## Description

The present invention relates to a method of and a controller for controlling electromagnetic devices or actuators of the type comprising a pair of electromagnetic coils and a movable member or body moved by the electromagnetic force thereof. Such an actuator can be incorporated in an electromagnetic valve for accurate fuel injection in a diesel engine or an electromagnetic shut off valve for example.

As described hereinafter, a known form of controller alternately energises one of a pair of solenoid coils to displace a movable body between set positions in response to a command signal. The known controller suffer from the disadvantage that it is not possible to instantaneous energise one coil and de-energise the other coil due to the inductance of the coils.

A general object of the present invention is to provide an improved form of controller and a method of control to enhance the response of the electromagnetic device.

US—A—4,154,198 describes, inter alia controllers for opening and closing a fluid valve which utilise a pair of electromagnetic coils. One coil is used to open the valve and the other coil is used to hold the valve in the opened state or to control backward flux.

As is known the invention provides a method of controllong a two-state electromagnetic device of the type employing a pair of electromagnetic coils and a body movable in a reciprocal manner between first and second positions and vice versa by energising the coils. In accordance with the invention the method comprises supplying a holding current to a first coil and a standby energising current to a second coil simultaneously to hold the body in the first position and in response to a command signal increasing the energising current to the second coil and decreasing the holding current in the first coil to move the body rapidly from the first position to the second position.

The invention also provides a controller with drive means with switches for establishing current paths through the coils in response to a change-over command signal as is known to move the body between first and second positions. In accordance with the invention the drive means is controlled by control means to supply currents to both the first and second coils simultaneously to maintain the body in the first position with a holding current in the first coil and a standby energising current in the second coil and which responds to the command signal to decrease the holding current in the first coil and increase the energising current in the second coil to effect the rapid movement of the body to the second position.

In general the energising current can be made equal to or greater than the holding current prior to change over. Prior to the movement of the body the energising current can be increased from a value less than the holding current to a value greater than the holding current. Prior to the increase in the energising current the holding current can also be increased.

To dissipate electromagnetic energy in the coils it is preferred to have a series circuit in parallel with each coil, each series circuit comprising a diode with opposite polarity to that of the coil energising current and a non-linear device which conducts when the back e.m.f. in the coil exceeds a predetermined value.

By establishing pre-set reference values representing a holding current and an energising current the control means can continuously compare these values with the dynamic currents flowing through the coils and the coils can be driven in a chopped-mode rising from and falling back to these reference values.

An embodiment of the invention will now be described, by way of example only, with reference to the accompanying drawings, wherein:

Figure 1 is an electrical circuit diagram of a controller constructed in accordance with the present invention;

Figure 2 is a sectional side view of an electromagnetic valve device employing a double-solenoid actuator;

Figure 3 depicts waveforms pertaining to the operation of the controller shown in Figure 1;

Figure 4 is a circuit diagram depicting a modified controller for use with fuel injection control means of an internal combustion engine;

Figure 5 depicts waveforms pertaining to the operation of the controller shown in Figure 4.

Figure 6 is an electrical circuit diagram of a typical known form of a controller for controlling an electromagnetic valve device or actuator;

Figure 7 depicts waveforms pertaining to the controller of Figure 6; and

Figure 8 is a graphical representation of force characteristics pertaining to an electromagnet.

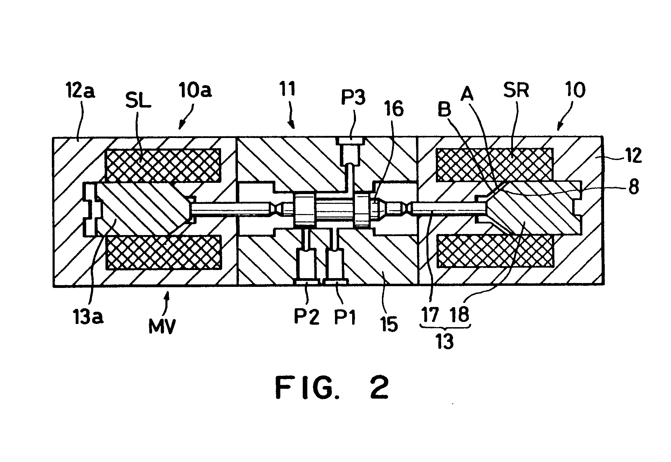

The electromagnetic valve device MV depicted in Figure 2 represents at least in part a typical electromagnetic actuator. The device MV has a pair of electromagnets namely a left electromagnet 10 and a right electromagnet 10a. A central portion of the device MV is constructed as a block 15 constituting a change-over valve 11 with ports P3, P1, P2 and a spool 16 guided for axial movement in the block 15. The electromagnet 10 has a plunger 13 guided for axial movement in a housing 12 forming a yoke for an electromagnetic coil SR surrounding the plunger 13. Similarly the electromagnet 10a has a plunger 13a guided for axial movement in a housing 12a forming a yoke for an electromagnetic coil SL surrounding the plunger 13a. The plungers 13, 13a have projecting rod portions (17) connected to or abutting the spool 16. During operation, when the coil SR is energised magnetic flux is created in the gap 8 between an inner end region A of the yoke 12 and the outer end region B of the plunger 13 and the resultant attractive force causes the plunger 13 to move to the left. When the coil SR is energised and the coil SL is deenergised the spool 16 is accordingly forced to the left to establish communication between the ports P1, P2. Conversely when the coil SR is deenergised and the coil SL is energised the spool 16 will be forced to the right to establish communication between the ports P1, P3.

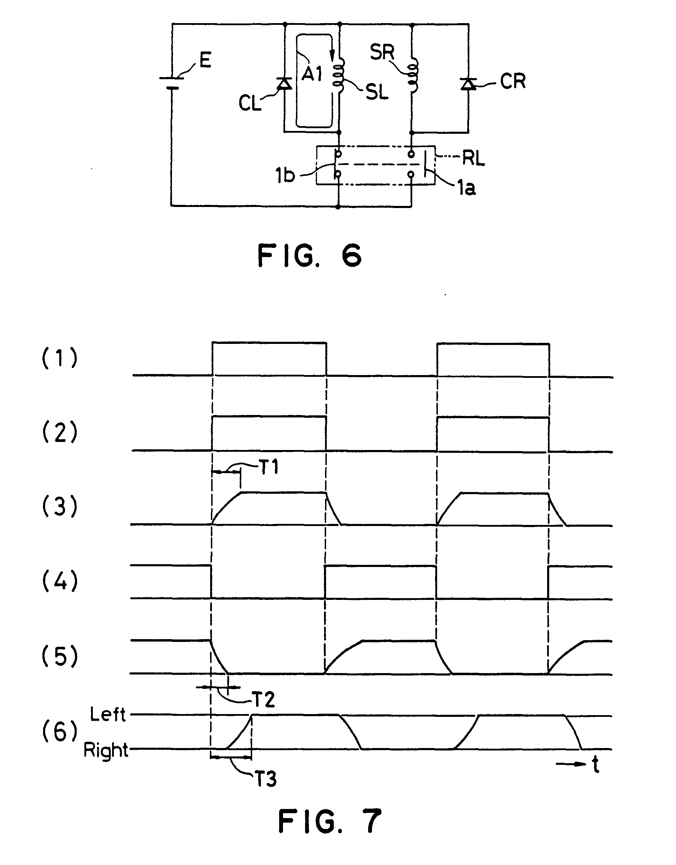

As shown in Figure 6, a controller for use with the valve device MV has the electromagnetic coils SR and SL of the latter connected in parallel with a source E of direct current. A relay RL has switch contacts 1a, 1b in series with the coils SR, SL which alternately energise these coils SR, SL. Diodes CR and CL are connected across the respective coils SR, SL in the opposite polarity to the energising current applied. In Figure 7 (1) is the change-over command signal applied to the relay RL, (2) is the voltage waveform applied to the coil SR, (3) is the waveform of current flowing through the coil SR, (4) is the voltage waveform applied to the coil SL, and (5) is the waveform of the current flowing through the coil SL. When the command signal is at a low level, the contacts 1a of the relay switch RL are open, the contacts 1b are closed, and the coil SL is energised. When the switchover command signal changes from a low level to a high level the relay switch RL switches over to close contacts 1a and open contacts 1b. The coil SR is then energised and the coil SL is deenergised. At this transition point the current IR flowing through the coil SR is:

$$IR = \frac{E}{R1}(1 - e^{-(R1/L1)t}) \qquad (1)$$

where E is the source voltage, R1 is the resistance of the coil SR, L1 is the inductance of the coil SR and t is time.

Hence, as shown in Figure 7 (3), there is a transient state over the time interval T1 before the current IR adopts its normal state. The current IL caused by the back e.m.f. produced when the coil SL is deenergised is conducted by the diode CL to flow as shown by the arrow A1 in Figure 6 and is:

$$IL = \frac{E}{R2}e^{-(R2/L2)t} \qquad (2)$$

where E is the source voltage, L2 is the inductance of the coil SL, R2 is the resistance of the coil SL and t is time. The current IL is dissipated by the resistance R2 of the coil SL to decay to a low level after the time interval T2 in Figure 7(5).

When a controller as shown in Figure 6 drives the double solenoid electromagnetic valve as shown in Figure 2, the movable valve element i.e. the valve spool 16 and the plungers 13, 13a of the pair of electromagnets 10, 10a are subjected to a force which is the difference between the electromagnetic force produced by the current IR flowing through the coil SR or SL, and, working against this, the electromagnetic force produced by the current IL flowing through the coil SL or SR when the command signal switches over. Typically the spool 16 moves from the right to the left in time interval T3 as shown in Figure 7(6).

For the movable element or spool to be moved at high speed by electromagnetic force as described above, the current flowing through the energised coil must be increased rapidly, and also the current flowing through the deenergised coil must be decreased rapidly. Because of the inductance of the coils, the rate of change of the respective currents is limited, and there is a limit to how fast the movable body can be forced to move. From expression (1) above if the supply voltage is increased the energising current will rise more rapidly, but since the normal steady state value of the energising current also increases, the heat dissipation rises, thereby increasing the resistance, so that no great benefit can be obtained by simply raising the supply voltage. Excessive voltage applied to the coil can cause the coil to burn out in any event.

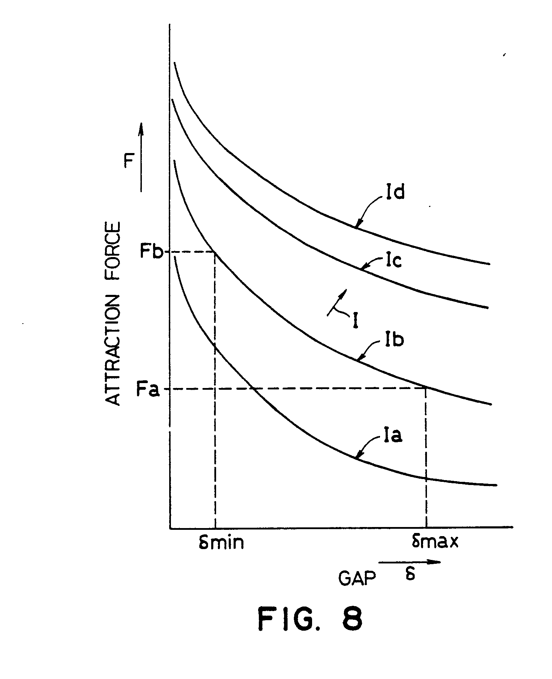

Figure 8 represents typical electromagnet attraction force characteristics. The relation between the electromagnet attraction force F and the electromagnet gap δ which causes the effective magnetic flux contributing to the attraction force is shown for different values of energising current I. In the drawing δmax is the maximum value of the gap δ, and δmin the minimum valve of the gap δ; the energising currents I are such that Ia is less than Ib which is less than Ic which in turn is less than Id. When the energising current I is Ib, and the gap δ is the maximum value δmax the attraction force is Fa, and when the gap δ is the minimum value δmin the attraction force is Fb. A pair of electromagnets having these force characteristics is used for example in the double solenoid electromagnetic valve MV of Figure 2. Thus, when the first electromagnet is attracting its plunger with the gap δmin, it will be producing the attraction force Fb, while the second electromagnet coil is energised, and with the gap δmax it will be producing the attractive force Fa. At this point, if the difference Fb−Fa of the attraction forces is greater than the external forces acting on the switchover valve spool, for example spring force or fluid force (that is forces acting on the spool as a result of fluid flow), then the spool will remain moved to the side of the second electromagnet, and that state will be preserved. From this state, if the current energising the coil of the first electromagnet is suddenly removed, the attraction force Fb will disappear, only the attraction force Fa will act on the spool, and the spool will move at high speed to the side of the first electromagnet.

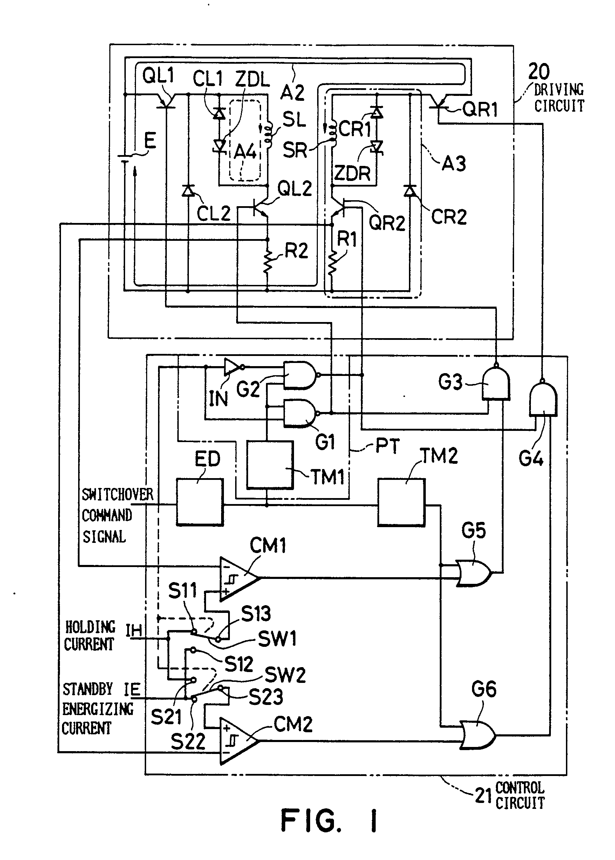

A controller as depicted in Figure 1 is suitable to drive the electromagnets 10 and 10a of the valve device MV shown in Figure 2. As shown in Figure 1, the controller is composed of a drive means 20 and control means 21. The drive means 20 which is associated with the electromagnetic coils SR and SL, and direct current supply E, as discussed previously, has switching transistor QR1, E, as discussed previously, has switching transistors QR1, QL1, QR2 and QL2 and resistors R1 and R2 for current detection. A diode CR1 and a Zener diode ZDR are connected in series across the coil SR. The diode CR1 has the opposite polarity to the direction of flow of the energising current of the coil SR, and the Zener diode ZDR has the opposite polarity to the polarity of the back e.m.f. generated in the coil SR. In a similar manner a diode CL1 and a Zener diode ZDL, are connected in series across the coil SL. A further diode CR2 is connected in parallel with the coil SR and the transistor QR2 and the resistor R1 and has the opposite polarity to the energising current of the coil SR. Similarly a diode CL2 is connected in parallel with the coil SL, the transistor QL2 and the resistor R2 and has the opposite polarity to the energising current of the coil SL.

The control means 21 is composed of an edge detector ED which detects rising and falling edges in a change-over command signal for switching over the position of the spool of a valve, a pre-energising timing circuit PT which sets the timing for carrying out pre-energising of the coils SR and SL, two change over switches SW1 and SW2, a timer TM2, comparators CM1 and CM2 having hysteresis characteristics, and a number of logic gates. The pre-energising timing circuit PT comprises a timer TM1, an inverter IN, and NAND gates G1 and G2.

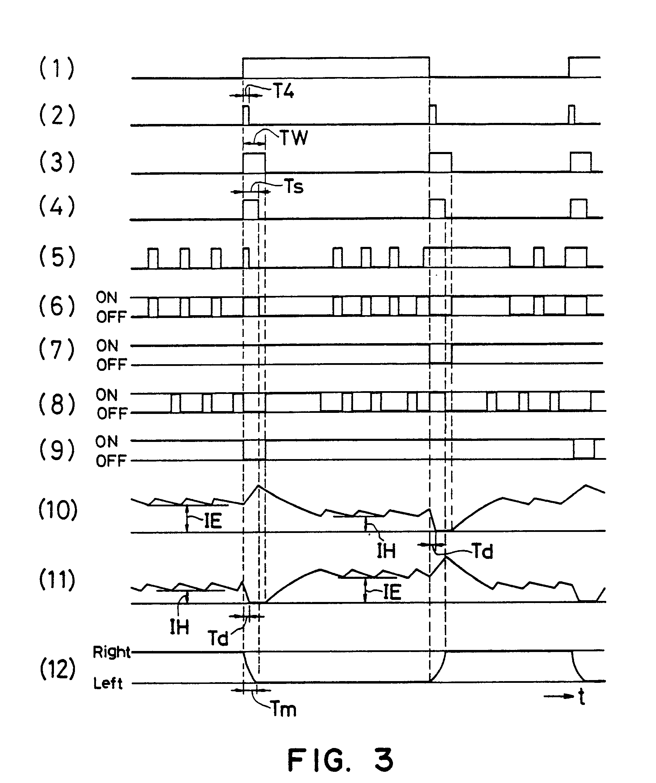

Figure 3 depicts waveforms illustrating the operation of the controller of Figure 1 wherein (1) is the changeover command signal, (2) is the output signal of the edge detector ED, (3) is the output signal from the timer circuit TM1, (4) is the output signal from the timer circuit TM2, (5) is the output of the comparator CM2, (6) is the operating state of transistor QR1, (7) is the operating state of transistor QR2, (8) is the operating state of transistor QL1, (9) is the operating state of transistor QL2, (10) is the current waveform flowing through the coil SR, (11) is the current flowing through the coil SL and (12) signifies the position changes of the spool 16 of the switchover valve 11.

When the spool 16 in Figure 2 is moved to the right of the drawing, and the electromagnet 10a is in the attracting state, the command signal is at a low level, and the output of the detector ED is at a low level. In this state the timer TM1 is not operating and its output will be at a low level while the outputs of NAND gates G1 and G2 are both at a high level. As a result, the transistors QR2 and QL2 will be in the on state. The command signal (1) will cause the switch SW1 to have its terminal S11 and the common terminal S13 connected, and a voltage corresponding to the holding current IH will be applied to the non-inverting input of the comparator CM1. The command signal (1) will also cause the switch SW2 to have its terminal S22 and the common terminal S23 connected, and a voltage corresponding to the standby energising current IE will be applied to the non-inverting input of the comparator CM2. When the current flowing through the coil SR is smaller than the standby energising current IE value, the output of the comparator CM2 will adopt a high level, the transistor QR1 will be turned on through gates G6 and G4, and current is supplied from the direct current supply E in the direction shown by the solid line arrow A2.

When the value of the current flowing through the coil SR becomes greater than the sum of the standby energising current value IE and the magnitude of the hysteresis value of the comparator CM2, the output of the comparator CM2 will change from a high level to a low level and the transistor QR1 will switch into the off state. Thus the current flowing in the coil SR will flow through the diode CR2 as shown by the dot-dot-dash line arrow A3, and will progressively diminish. When the current again becomes less than the standby energising current value IE, the transistor QR1 will be switched on. As a result, since the on/off operation of the transistor QR1 is repeated, the coil SR will be driven in the chopper mode of the standby energising current IE as shown in Figure 3(10). On the other hand, the current flowing through the coil SL detected by the resistor R2 is compared with the holding current value IH in the comparator CM1, and when the current flowing through the coil SL is smaller than the holding current IH the output of the comparator CM1 will be at a high level. Conversely, when the current becomes greater than the sum of the holding current value IH and the magnitude of the hysteresis value of the comparator CM1, the output of the comparator CM1 will change to a low level. When the output of the comparator CM1 is high, the output of NAND gate G3 will be low, and when the output of the comparator CM1 is low, the output of NAND gate G3 will be high. As a result, since the on/off operation of the transistor QL1 is repeated, the coil SL will be driven in the chopper mode of the holding current value IH as shown in Figure 3(11).

In the first section of Figure 3(10) and (11) the current flowing through the coil SR is greater than the current flowing through the coil SL, but the electromagnet gap on the side of the coil SL is at a minimum while the gap on the side of the coil SR is at a maximum, so that the attraction force of the electromagnet 10 on the side of the coil SR is smaller than the attraction force of the electromagnet 10a on the side of the coil SL. Therefore the spool 16 of the switchover valve will remain pressed to the right as shown in Fig. 2.

When the switchover command signal (1) changes from low to high, the edge detector ED detects this rising edge, and outputs a high level signal for exactly the interval T4 shown in Fig. 3(1), and the TM1 and TM2 operate. Thus the timer TM1 outputs a high level for exactly a time interval TW, as shown in Fig. 3(3). Even if the high level output of timer circuit TM1 is applied to the NAND gate G2, since the output of the inverter IN is low, the output of gate G2 will remain in the high level state, and the transistor QR2 will continue in the on state as shown in Fig. 3(7). On the other hand, when the high level output of the timer TM1 is applied to the NAND gate G1, for just the interval Tw, the output of the NAND gate G1 will be low and the transistor QL2 will adopt the off state as shown in Fig. 3(9). When the transistor QL2 goes into the off state, the current flowing through the coil SL will flow in a direction through the Zener diode ZDL and diode CL1 as shown by the broken line arrow A4, and will rapidly dissipate. When the output of the timer TM2 goes high for exactly the time interval Ts, the transistor QR1 will be turned on through the OR gate G6 and NAND gate G4, and the current flowing in the coil SR will increase. In other words, the current in the coil SL of the electromagnet which was attracting will be rapidly dissipated, and the current flowing in the coil SR of the electromagnet which is newly attracting will increase further beyond the value IE of the standby energizing current, and by increasing the attraction force, as shown in Fig. 3(12) the spool 16 of the switchover valve 11 can be moved to the left at an extremely high speed. At this time, the switch SW2 has its terminal S21 and the common terminal S23 connected, and the holding current value IH is fed to the non-inverting input of the comparator CM2. When the output of the timer TM2 becomes low an interval Ts later, the output of the OR gate G6 is controlled by the output of the comparator CM2, and the transistor QR1 goes into an on/off state depending on that output, and the coil SR is driven by the holding current IH in a chopper mode as shown in Fig. 3(10). On the other hand, the standby energizing current value IE is applied through the switch SW1 to the comparator CM1. After an interval Tw has elapsed the output of the NAND gate G1 is restored to the high level and the transistor QL1 is put in an on/off state by the output of the comparator CM2. The coil SL, as shown in Fig. 3(11), will be driven in a chopper mode at a rated current value of the standby energizing current value IE. At this time the spool 16 of the switchover valve 11 will remain urged to the left for the same reason as when the command signal is at the high level.

When the command signal goes from the high level to the low level, the edge detector ED again detects the falling edge in this signal, the timers TM1 and TM2 are activated, the current flowing in the coil SR is rapidly dissipated, the current flowing in the coil SL is increased, and as shown in Fig. 3(12), the spool 16 of the switchover valve 11 is moved to the right. In order to increase the frequency of switching the switchover valve, the set time Tw of the timer TM1 is set slightly longer than the current dissipation time Td of the coils SR and SL as shown in Fig. 3(10) and Fig. 3(11), and the set time Ts of the timer circuit TM2 is set equal to or slightly longer than the spool movement time Tm.

In the present embodiment, the standby energizing current value is made large, the attraction force is made large, and the holding current is made small, in order to make short the dissipation time Td of the current flowing through the coils SR and SL, but the standby energizing current IE and the holding current IH may be made equal in order to simplify the design.

In the present invention, the dissipation or decay time Td of the current flowing through the coils SR and SL is of prime concern, and since the rise time of the energising current is not so important a relatively low supply voltage may be used. From expression (1) if the required peak current (current required to obtain the spool movement time T3) when energizing is ID, and the coil inductance is L, the time Tr to reach this is given by:

$$Tr = \frac{L}{E} \cdot ID \qquad (3)$$

On the other hand, if the Zener voltage is VZ, the time Th from the holding current IH until the energizing current is dissipated is given by:

$$Th = \frac{L}{VZ} \cdot IH \qquad (4)$$

The value of the holding current IH may be made between 1/2 and 1/5 of the required peak energizing current ID, and rather than making the supply voltage E large, it is easier from the point of view of circuit design to make the Zener voltage VZ large, and therefore compared with current technology a great speed improvement may be made. It should be noted that although a Zener diode has been used as the nonlinear element in the dissipation circuit, a varistor (voltage dependent resistor element) may equally be used to the same effect.

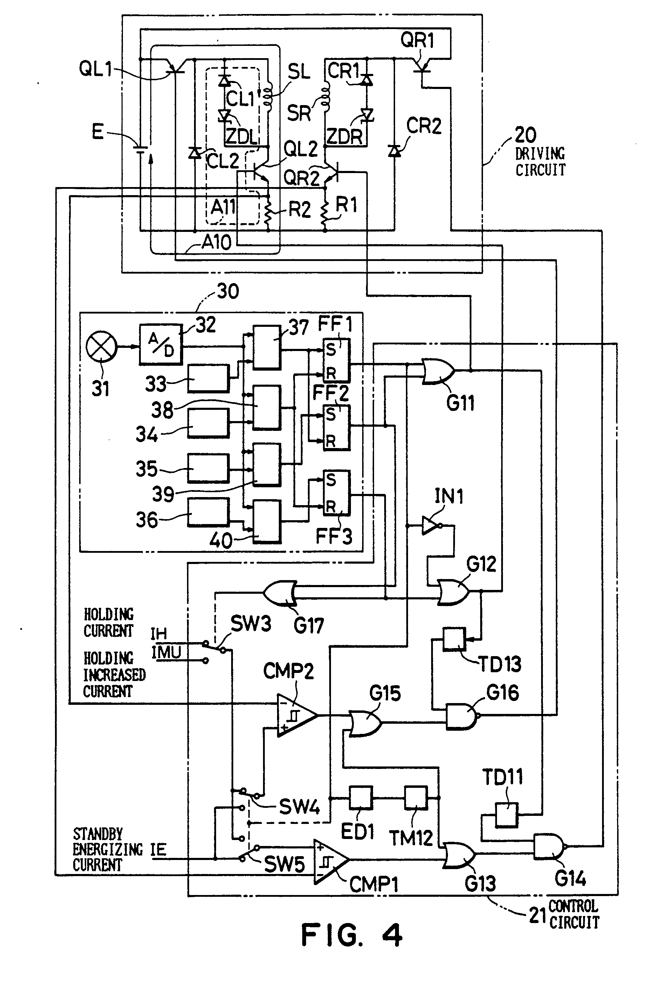

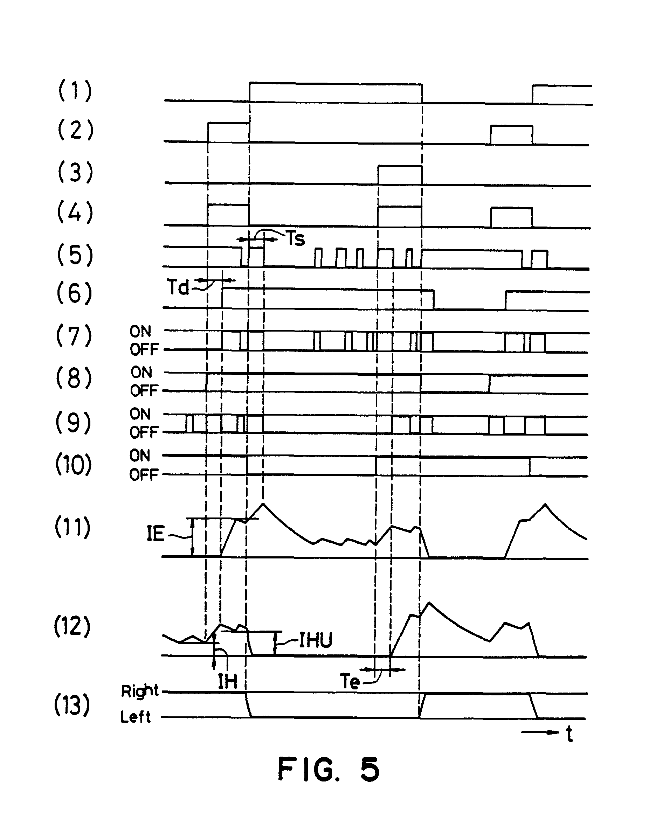

An embodiment of the present invention applied to a fuel injection control device 30 of an internal combustion engine is shown in Fig. 4, and the associated waveforms in Fig. 5. In Fig. 5(1) is the command signal being the output of an RS flip-flop FF1, (2) is a pre-energizing signal of the coil SR being the output of an RS flip-flop FF2(3) is a pre-energizing signal of the coil SL being the output of an RS flip-flop FF3, (4) is the output signal of OR gate G17, (5) is the output signal of OR gate G13, (6) is the output signal of timer TD11, (7) is the operating state of transistor QR1, (8) is the operating state of transistor QR2, (9) is the operating state of transistor QL1, (10) is the operating state of transistor QL2, (11) is the current waveform flowing through coil SR, (12) is the current flowing through coil SL, and (13) represents the position changes of the valve spool. When the spool is in the left position fuel is being injected, and when in the right position it is stopped. In Fig. 4 one electromagnet valve control unit is shown and the remaining control units are omitted. A resolver 31 detecting the crank angle of an engine is fitted to the crank, the analog output of this resolver 31 is applied to the A/D converter 32, which provides a digital signal representing crank angle information. The output signal of the A/D converter 32 and the signals from a fuel injection start setting means 33, a fuel injection finish setting means 34, the pre-energizing timing setting means 35 of the coil SR, and the pre-energizing timing setting means 36 of the coil SL are input to testing means 37 to 40 respectively which test to see if they are in agreement, and produce an output signal if they are in agreement. The fuel injection start timing is set by the crank angle, and the completion timing is determined by the revolution count control system, which is set by conversion from the crank angle. The timing of the fuel injection start setting is restricted to the range of 30 to 0 degrees before top dead center (TDC) of the piston, preceding that, the pre-energizing timing of the coil SR is set at 50 degrees before top dead center TDC, and the pre-energizing timing of the coil SL is set at a crank angle preceding the fuel injection finish timing. The crank angle changes as the engine rotates, and as each of the setting values agrees with the output signal of the A/D converter 32, pulse signals are produced by the decision circuit 37 to 40. As these pulse signals trigger the next stage RS flip-flops FF1 to FF3, from these outputs are obtained, from the fuel injection start the switchover command signal for the end thereof, from the pre-energizing timing of the coil SR until the start of fuel injection the pre-energizing signal of the coil SR, and from the pre-energizing timing of the coil SL until the finish of fuel injection the pre-energizing signal of the coil SL.

When the command signal which is the output of the RS flip-flop FF1, and the pre-energizing command signal of the coil SR which is the output of RS flip-flop FF2, are both at a low level, the output of OR gate G11 is low and the transistor QR2 will be off. The output of the OR gate G11 is applied through the timer delay circuit TD11 to NAND gate G14, and as a result the output of the NAND gate G14 will be high and the transistor QR1 will go off, and the current in the coil SR will be dissipated. On the other hand, the gate G12 has one input to which is applied the output of the inverter IN1 and since its output is high, transistor QL2 adopts the on state. Again, since the output of the OR gate G17 is low level, the holding current value IH is selected by the switch SW3, and the output of switch SW3 is selected by the switch SW4. The holding current value IH is applied to the non-inverting input of a comparator CMP2 which has a hysteresis characteristic, and the current flowing through the coil SL is detected by the resistor R2, and applied to the inverting input of the comparator CMP2. Since the edge detector ED1 is outputting a low level, the timer TM12 does not operate, and its output is maintained low, as a result of which one input of the OR gate G15 is low, and also the output of the OR gate G12 will pass through TD13 and feed a high level input to the NAND gate G16, so that the output of the comparator CMP2 will turn the transistor switch QL1 on and off. Current will flow in the direction in the coil SL as shown by the solid line arrow A10 and broken line arrow A11 in the drawing, and the coil SL is thus driven in a chopper mode at a rated current of the holding current IH. At this time, the electromagnet on the coil SL side is attracting, and the gap is small, so the spool of the switchover valve is pulled in the direction of the coil SL.

When the pre-energizing signal of the coil SR goes to the high level, the output of the OR gate G17 will go to the high level, and the holding increased current IMU will be selected by the switch SW3. The current applied to the coil SL is increased, and it is driven in the chopper mode with a rated current of the holding increased current value IMU. On the other hand, the output of the gate G11 is high, and the transistor QR2 adopts the on state, but the output of TD11 still continues at the low level for the interval TD. Therefore the output of the NAND gate G14 is also maintained at the high level, as a result of which the transistor QR1 continues in the off state, and current does not flow through the coil SR. When the interval Td has elapsed the output of the TD11 becomes high and the output of TM12 is maintained at the low level, so that the comparator CMP1 having a hysteresis characteristic puts the transistor QR1 in the on/off state. Since the switchover command output of the RS flip-flop FF1 is low the standby energizing current IE is selected by the switch SW5, this current IE is applied to the non-inverting input terminal of the comparator CMP1, and the current flowing through the coil SR detected by the resistor R1 is inputted to the inverting input of the comparator CMP1. The coil SR is therefore driven in a chopper mode with a rated current of the standby energizing current value IE, and goes on standby. In the interval, the force maintaining the spool of the switchover valve on the left side is reduced by the attraction force of the coil SR, but since before then the current of the coil SL was increased from the holding current IH to the holding increased current IMU, there is no decrease in the coil SL attraction force compared with when it was driven in chopper mode with a rated current of the holding current value IH. If the attraction force for the holding current IH is very much larger than the fluid forces, the function of setting the holding increased current may be omitted, but in that case, compared with the case where the setting of the holding increased current function is necessary, the temperature increase of the electromagnet coils is greater, and the efficiency of the power supply is inferior. When the engine rotates and the crank angle coincides with the fuel injection start setting, the switchover command from the output of RS flip-flop FF1 changes from a low level to a high level, and the pre-energizing signal for the coil SR which is the output of the RS flip-flop FF2 changes from high to low. The output of the OR gate G12 goes to a low level, the transistor QL2 adopts the off state, and the current flowing through the coil SL passes through the Zener diode ZDL and the diode CL1 and is rapidly dissipated. The output of the OR gate G11 remains at the high level, so that the transistor QR2 stays in the on state. The edge detector ED1 detects e switchover command rising edge and sends out a pulse signal, the timer TM12 is operated, and the output of the OR gate G13 is set to a high level for the interval Ts. Since also the output of the timer delay circuit TD11 has already become high the output of the NAND gate G14 is low, and the transistor QR1 is put in the on state. In other words the current flowing in the coil SL is dissipated, and its attraction force is lost, whereas the current flowing in the coil SR is further increased, and an increase in the attraction force is obtained, so that the operation of the spool of the switchover valve can be speeded up. When the interval Ts set by the timer circuit TM12 has elapsed, the output of the timer TM12 returns to the low level, and since the holding current value IH is applied to the comparator CMP1 through the switchover switches SW3 and SW5, the coil SR is driven in chopper mode with a rated current value of the holding current value IH.

As the engine rotates further, and the crank angle comes into agreement with the timing of the pre-energizing current for the coil SL, the output of the RS flip-flop FF3 which is the pre-energizing command signal for the coil SL becomes high, the coil SR switches to be driven in chopper mode with a rated current of the holding increased current value IMU, and after the interval Te set by the timer TD13, the coil SL is driven in chopper mode with a rated current value of the standby energizing current value IE, and goes into standby. When, in agreement with the fuel injection finish timing, the output of the RS flip-flop FF1 which is the switchover command signal, and the output of the RS flip-flop FF3 which is the pre-energizing command signal for the coil SL both go to a low level, the transistor QR2 adopts the off state. The current flowing in the coil SR is rapidly dissipated, and in the setting interval Ts of the timer circuit TM12 the transistor QL1 is forcibly turned on, so that the current flowing in the coil SL is increased. After that, the coil SR is driven in chopper mode with a rated current value of the holding current value IH, and the original state is adopted.

As above, according to the present invention, using a relatively low supply voltage it is possible to operate an electromagnetic actuator or device at high speed; the many advantageous features include good responsiveness of the electromagnet device and high reliability, and it is ideal for fine control in response to instrumentation, and for automatic computer control.

**Claims**

1. A method of controlling a two-state electromagnetic device of the type employing a pair of electromagnetic coils and a body movable in a reciprocal manner between first and second positions and vice versa by energising the coils; said method comprising supplying a holding current (IH) to a first coil (SR) and a standby energising current (IE) to a second coil (SL) simultaneously to hold the body in the first position and in response to a command signal increasing the energising current to the second coil and decreasing the holding current in the first coil to move the body rapidly from the first position to the second position.

2. A method according to claim 1, wherein the energising current is made equal to or greater than the holding current prior to the change over.

3. A method according to claim 1, wherein prior to movement of the body the energising current is increased from a value less than the holding current to a value greater than the holding current.

4. A method according to claim 3, wherein prior to the increase in the energising current the holding current is increased.

5. A controller for carrying out the method of claim 1 in controlling a two-state electromagnetic device of the type employing a pair of electromagnetic coils (SL, SR) and a body (13, 16) reciprocally movable in relation to the coils between first and second positions and vice versa; said controller comprising drive means (20) with switches (QR1, QR2, QL1, QL2) for establishing current paths through the coils (SR, SL) in response to a change-over command signal to move the body between the first and second positions; characterised by control means (21) for controlling the drive means to supply currents to both the first and second coils (SR, SL) simultaneously to maintain the body (13, 16) in the first position with a holding current (IH) in the first coil (SR) and a standby energising current (IE) in the second coil and which responds to the command signal to decrease the holding current in the first coil (SR) and increase the energising current in the second coil to effect the rapid movement of the body (13, 16) to the second position.

6. A controller according to claim 5, wherein the control means controls the drive means to make the energising current (IE) equal to or greater than the holding current (IH) prior to changeover.

7. A controller according to claim 5 or 6, wherein there is provided a series circuit in parallel with each coil (SR, SL), each series circuit comprising a diode (CR1, CL1) with opposite polarity to that of the coil energising current and non-linear device (ZDR, ZDL) which conducts when the back e.m.f. in the coil exceeds a predetermined value.

8. A controller according to claim 5, 6, or 7, wherein the drive means (20) provides chopped mode currents to the coils (SR, SL).

9. A controller according to any one of claims 5 to 8 wherein the control means (21) includes comparators (CM1, CM2) receiving inputs representing the currents through the coils (SR, SL) and current reference values (IE, IH), timers (TM1, TM2) for providing time-delayed signals and a series of logic gates which serve to control the operation of the switches (QR1, QL1, QR2, QL2).

10. A controller according to claim 9, wherein the control means (21) further comprises switches (SW1, SW2) which respond to the command signal to input the current reference values to one or other of the comparators (CM1, CM2).

11. A controller according to claim 9 or 10, wherein the control means (21) further comprises an edge detector (ED) for detecting changes in the command signal and for enabling the timers (TM1, TM2) in response to such changes.

12. A controller according to claim 5, wherein the control means (21) serves to increase the holding current in the first coil (SR) prior to its decrease.

## Patentansprüche

1. Verfahren zum Steuern einer elektromagnetischen Vorrichtung mit zwei Betriebszuständen, mit zwei Magnetspulen und einem durch deren Erregung zwischen zwei Positionen hin und her bewegbaren Körper, gekennzeichnet, durch die gleichzeitige Zuführung eines Haltestroms (IH) zur ersten Spule (SR) und eines Vorerregungsstroms (IE) zur zweiten Spule (SL), um den Körper in der ersten Position zu halten, und durch die Erhöhung des Vorerregungsstroms der zweiten Spule und die Verringerung des Haltestroms der ersten Spule als Reaktion auf ein Befehlssignal, um den Körper schnell von der ersten Position in die zweiten Position zu bewegen.

2. Verfahren nach Anspruch 1, dadurch gekennzeichnet, daß vor dem Umschalten der Wert des Vorerregungsstroms gleich oder größer als der Wert des Haltestroms gemacht wird.

3. Verfahren nach Anspruch 1, dadurch gekennzeichnet, daß vor der Bewegung des Körpers der Vorerregungsstrom von einem geringeren Wert der Haltestrom auf einen größeren Wert als der Haltestrom erhöht wird.

4. Verfahren nach Anspruch 3, dadurch gekennzeichnet, daß vor der Erhöhung des Vorerregungsstromes der Haltestrom erhöht wird.

5. Einrichtung zur Durchführung des Verfahrens nach Anspruch 1 zum Steuern einer elektromagnetischen Vorrichtung mit zwei Betriebszuständen, mit zwei Magnetspulen (SL, SR) und einem bezüglich der Spulen zwischen zwei Positionen hin und her bewegbaren Körper (13, 16), wobei die Steuerungseinrichtung Antriebsmittel (20) mit Schaltern (QR1, QR2, QL1, QL2) umfaßt zum Herstellen von Stromwegen durch die Spulen in Reaktion auf ein Umschalt-Befehlssignal, um den Körper von der einen in die andere Position zu bewegen, gekennzeichnet durch Steuermittel (21) zum Steuern der Antriebsmittel, damit diese den Spulen (SR, SL) zwei Ströme gleichzeitig zuleiten, nämlich der ersten Spule (SR) einen Haltestrom (IH) und der zweiten Spule einen Vorerregungsstrom (IE), um den Körper in der ersten Position zu halten, welche Steuermittel in Reaktion auf das Befehlssignal den Haltestrom in der ersten Spule (SR) verringern und den Vorerregungsstrom in der zweiten Spule erhöhen, um die schnelle Bewegung des Körpers (13, 16) in die zweite Position zu bewirken.

6. Einrichtung nach Anspruch 5, dadurch gekennzeichnet, daß die Steuermittel die Antriebsmittel so steuern, daß diese vor dem Umschalten den Vorerregungsstrom (IE) dem Haltestrom (IH) gleich- oder höher als diesen setzen.

7. Einrichtung nach Anspruch 5 oder 6, dadurch gekennzeichnet, daß parallel zu jeder Spule (SR, SL) eine Serienschaltung vorgesehen ist, von denen jede eine Diode (CR1, CL1) mit einer der Polarität des Erregungsstromes der betreffenden Spule entgegengesetzten Polarität und eine nichtlineare Vorrichtung (ZDR, ZDL) aufweist, welch letztere leitet, wenn die Gegen-EMK in der Spule einen vorbestimmten Wert überschreitet.

8. Einrichtung nach Anspruch 5, 6, oder 7, dadurch gekennzeichnet, daß die Antriebsmittel (20) im Unterbrechungsmodus Ströme zu den Spulen (SR, SL) abgeben.

9. Einrichtung nach einem der Ansprüche 5 bis 8, dadurch gekennzeichnet, daß die Steuermittel (21) Vergleicher (CM1, CM2), denen einerseits für die Ströme durch die Spulen (SR, SL) repräsentative Eingangssignale und andererseits Vergleichsstromwerte (IE, IH zugeführt werden, Zeitgeber (TM1, TM2) zur Abgabe von zeitverzögerten Signalen und eine Reihe von Logikgattern, die zur Steuerung der Funktion der Schalter (QR1, QL1, QR2, QL2) dienen, umfassen.

10. Einrichtung nach Anspruch 9, dadurch gekennzeichnet, daß die Steuermittel (21) außerdem Schalter (SW1, SW2) umfassen, die in Reaktion auf das Befehlssignal die Vergleichsstromwerte in einen der beiden Vergleicher (CM1, CM2) eingeben.

11. Einrichtung nach Anspruch 9 oder 10, dadurch gekennzeichnet, daß die Steuermittel (21) außerdem einen Flankendetektor (ED) aufweisen zur Erfassung von Änderungen im Befehlssignal und zum Freigeben der Zeitgeber (TM1, TM2) als Reaktion auf solche Änderungen.

12. Einrichtung nach Anspruch 5, dadurch gekennzeichnet, daß die Steuermittel (21) dazu dienen, den Haltestrom in der ersten Spule (SR) vor seiner Absenkung zu erhöhen.

## Revendications

1. Procédé de commande d'un dispositif électromagnétique à deux états du type utilisant une paire de bobines électromagnétiques et un corps mobile d'une manière alternative entre une première et une seconde positions et réciproquement par l'excitation des bobines; ledit procédé consistant à fournir un courant de maintien (IH) à une première bobine (SR) et un courant d'excitation d'attente (IE) à une seconde bobine (SL) simultanément pour maintenir le corps dans la première position et, en réponse à un signal de commande qui augmente le courant d'excitation de la seconde bobine et qui diminue le courant de maintien dans la première bobine, à déplacer le corps rapidement de la première position à la seconde position.

2. Procédé selon la revendication 1, dans lequel le courant d'excitation est rendu égal ou supérieur au courant de maintien avant la permutation.

3. Procédé selon la revendication 1, dans lequel, avant le mouvement du corps, le courant d'excitation est augmenté d'une valeur inférieure à celle du courant de maintien jusqu'à une valeur supérieure à celle du courant de maintien.

4. Procédé selon la revendication 3, dans lequel, avant l'augmentation du courant d'excitation, le courant de maintien est augmenté.

5. Dispositif de commande destiné à mettre en oeuvre le procédé de la revendication 1 pour la commande d'un dispositif électromagnétique à deux états du type utilisant une paire de bobines électromagnétiques (SL, SR) et un corps (13, 16) mobile alternativement par rapport aux bobines entre une première et une seconde positions et réciproquement; ledit dispositif de commande comprenant des moyens d'attaque (20) avec des commutateurs (QR1, QR2, QL1, QL2), destinés à établir des circuits de courant par les bobines (SR, SL) en réponse à un signal de commande permutation pour déplacer le corps entre la première et la seconde positions; caractérisé par des moyens de commande (21) destinés à commander les moyens d'attaque de manière à fournir des courants à la première et à la seconde bobines (SR, SL) simultanément pour maintenir le corps (13, 16) dans la première position avec un courant de maintien (IH) dans la première bobine (SR) et un courant d'excitation d'attente (IE) dans la seconde bobine et qui réagit au signal de commande en augmentant le courant de maintien dans la première bobine (SR) et en augmentant le courant d'excitation dans la seconde bobine pour effectuer le mouvement rapide du corps (13, 16) vers la seconde position.

6. Dispositif de commande selon la revendication 5, dans lequel les moyens de commande commandent les moyens d'attaque pour rendre le courant d'excitation (IE) égal ou supérieur au courant de maintien (IH) avant une permutation.

7. Dispositif de commande selon la revendication 5 ou 6, dans lequel est prévu un circuit en série, en parallèle avec chaque bobine (SR, SL), chaque circuit en série comportant une diode (CR1, CL1) avec un polarité opposée à celle du courant d'excitation de la bobine et un dispositif non linéaire (ZDR, ZDL) qui est conducteur quand la force contre-électromotrice dans la bobine dépasse une valeur prédéterminée.

8. Dispositif de commande selon la revendication 5, 6 ou 7, dans lequel les moyens d'attaque (20) produisent des courants en mode découpé pour les bobines (SR, SL).

9. Dispositif de commande selon l'une quelconque des revendications 5 à 8, dans lequel les moyens de commande (21) comprennent des comparateurs (CM1, CM2) qui reçoivent des entrées représentant les courants dans les bobines (SR, SL) et des valeurs de référence de courant (IE, IH), des temporisateurs (TM1, TM2) qui produisent des signaux retardés dans le temps et une série de portes logiques servant à commander le fonctionnement des commutateurs (QR1, QL1, QR2, QL2).

10. Dispositif de commande selon la revendication 9, dans lequel les moyens de commande (21) comprennent en outre des commutateurs (SW1, SW2), qui réagissent au signal de commande en appliquant les valeurs de référence de courant à l'un ou à l'autre des comparateurs (CM1, CM2).

11. Dispositif de commande selon la revendication 9 ou 10, dans lequel les moyens de commande (21) comportent en outre un détecteur de transition (ED) destiné à détecter des variations du signal de commande et à activer les temporisateurs (TM1, TM2) en réponse à ces variations.

12. Dispositif de commande selon la revendication 5, dans lequel les moyens de commande (21) servent à augmenter le courant de maintien dans la première bobine (SR) avant qu'il ne diminue.

FIG. I

FIG. 2

FIG. 3

**FIG. 4**

**FIG. 5**

FIG. 6

FIG. 7

FIG. 8